# EUROPEAN PATENT APPLICATION

(11) **EP 4 329 105 A1**
(43) Date of publication of application: **28.02.2024**
(21) Application number: 21937822.1
(22) Date of filing: 19.04.2021
(51) Int. Cl.: H01R 12/77, H01R 13/6471

(54) **CONNECTOR AND HIGH-FREQUENCY SIGNAL TRANSMISSION DEVICE**

(71) Applicant: Yamaichi Electronics Co., Ltd., Tokyo 144-8581 (JP)
(72) Inventor: TAKAHIRA, Hiroshi, Tokyo 144-8581 (JP); YONEZAWA, Akira, Tokyo 144-8581 (JP)
(74) Representative: Müller-Boré & Partner Patentanwälte PartG mbB
(86) International application number: PCT/JP2021/015933
(87) International publication number: WO 2022/224324

(57) **Abstract**

Connector (1,2) to which a high-frequency signal transmission cable (4) is electrically coupled includes: an insulator (11); a group of contact terminals (12) including at least M (M indicating a natural number of 2 or more) unit arrays (C1-C8) arranged in a width direction of the insulator (11), each unit array including one or more signal contact terminals (12S) and one or more ground contact terminals (12G). The insulator (11) includes an insulator body (21) and at least M attachment members (22) which are attached to the insulator body (21) and arranged in the width direction of the insulator (11). The respective unit arrays included in the at least M unit arrays (C1-C8) are respectively supported by the respective attachment members included in the at least M attachment members (22).

## Description

### [Technical field]

The present disclosure is directed to connector and high-frequency signal transmission device.

### [Background Art]

There is a demand for high-frequency signal transmission connectors to enable faster signal transmission. Patent literature 1 discloses that width of contact terminal of connector is adjusted to effect impedance-matching. Patent literature 2 discloses that a common contact is used to equalize potential of the ground contact terminals by which the signal contact terminals are interposed, for a purpose of reduction of crosstalk during faster signal transmission.

### [Citation List]

### [Patent literature]

[PTL 1] Japanese patent application Laid-open No.2014-164884
[PTL 2] Japanese patent application Laid-open No.2013-84577

### [Summary]

### [Technical Problem]

In conventional connectors, a multiplicity of contact terminals is supported by a common insulator. The present inventors have reviewed such a conventional configuration and have newly identified a significance in providing a connector adaptable to further higher signal transmission frequency.

### [Solution to Problem]

A connector according to an aspect of the present disclosure is a connector to which a high-frequency signal transmission cable is electrically coupled, the connector including: an insulator; a group of contact terminals including at least M (M indicating a natural number of 2 or more) unit arrays arranged in a width direction of the insulator, each unit array including one or more signal contact terminals and one or more ground contact terminals. The insulator includes an insulator body and at least M attachment members which are attached to the insulator body and arranged in the width direction of the insulator. The respective unit arrays included in the at least M unit arrays are respectively supported by the respective attachment members included in the at least M attachment members. Each unit array may include 4 contact terminals in which a pair of signal contact terminals are interposed between two ground contact terminals (in other words, arranged between the two ground contact terminals), not necessarily limited to this though. The attachment member may retain an electroconductive part that electrically couple the two ground contact terminals included in the 4 contact terminals.

Width of receiving groove of the insulator body may be set corresponding to (i.e. in synchronization with) width change of arm of the contact terminal. For example, the receiving groove has a first groove width for receiving an arm plate of the contact terminal and a second groove width for receiving an arm bar of the contact terminal which is narrower than the first groove width. Note that the arm bar is located farther from the attachment member than the arm plate (i.e. positioned at the side of the terminal end of the contact terminal), and narrower in width than the arm plate. The receiving groove may have a minimum groove width at a position corresponding to a contact portion of the contact terminal.

Respective recesses of attachment members which are adjacent in the width direction of the insulator may be combined to form an insertion slot for a metal fixing member. The metal fixing member may have an insertion portion inserted into the insertion slot. This insertion portion may have a width that varies in the insertion direction of the insertion portion into the insertion slot.

In some embodiments, the connector further includes at least M electroconductive parts. Respective electroconductive parts included in the at least M electroconductive parts may be respectively retained by respective attachment members included in the at least M attachment members. Number of the metal fixing member may be M+1.

The attachment member may have an insertion hole to which the electroconductive parts is inserted, and may support the signal contact terminal and the ground contact terminal such that the signal contact terminal and the ground contact terminal have exposed portions in the insertion hole.

A high-frequency signal transmission device according to another aspect of the present disclosure includes a connector described above, and a high-frequency signal transmission cable electrically coupled to the connector. The high-frequency signal transmission cable includes M signal transmission channels.

### [Advantageous Effects of Invention]

According to an aspect of the present disclosure, it may be possible to provide connectors adaptable to further higher signal transmission frequency.

### [Brief Description of Drawings]

[Fig. 1] Fig. 1 is a schematic perspective view of a high-frequency signal transmission device according to an aspect of the present disclosure.
[Fig. 2] Fig. 2 is a schematic bottom view of a cable device.
[Fig. 3] Fig. 3 is a diagram illustrating a schematic and partial cross-section of FPC.
[Fig. 4] Fig. 4 is a schematic and partial bottom view illustrating an end of FPC.
[Fig. 5] Fig. 5 is a schematic perspective view of connector illustrating its front side.
[Fig. 6] Fig. 6 is a schematic perspective view of connector illustrating its rear side.
[Fig. 7] Fig. 7 is a schematic exploded perspective view of the connector, mainly illustrating that 8 attachment members and 9 metal fixing members are separated rearward from an insulator body.
[Fig. 8] Fig. 8 is a diagram illustrating that 4 contact terminals in GSSG array are respectively received by 4 receiving grooves formed on a bottom plate of the insulator body.
[Fig. 9] Fig. 9 is a diagram illustrating a schematic cross-section taken along an alternate long and short dash line X9-X9 in Fig. 8.
[Fig. 10] Fig. 10 is a schematic exploded perspective view of attachment member, illustrating a state where an electroconductive part is detached from the attachment member.
[Fig. 11] Fig. 11 is a schematic top view of attachment member.
[Fig. 12] Fig. 12 is a schematic cross-sectional view taken along an alternate long and short dash line X12-X12 in Fig. 11.
[Fig. 13] Fig. 13 is a schematic partial rear view of connector.
[Fig. 14] Fig. 14 is a diagram illustrating a state where the FPC is inserted into the connector and the both are electrically coupled.
[Fig. 15] Fig. 15 is a diagram showing a result of simulation.
[Fig. 16] Fig. 16 shows a result of simulation of a connector according to a comparative example.
[Fig. 17] Fig. 17 shows a result of simulation of a connector according to an embodiment of the present disclosure.

### [Description of Embodiments]

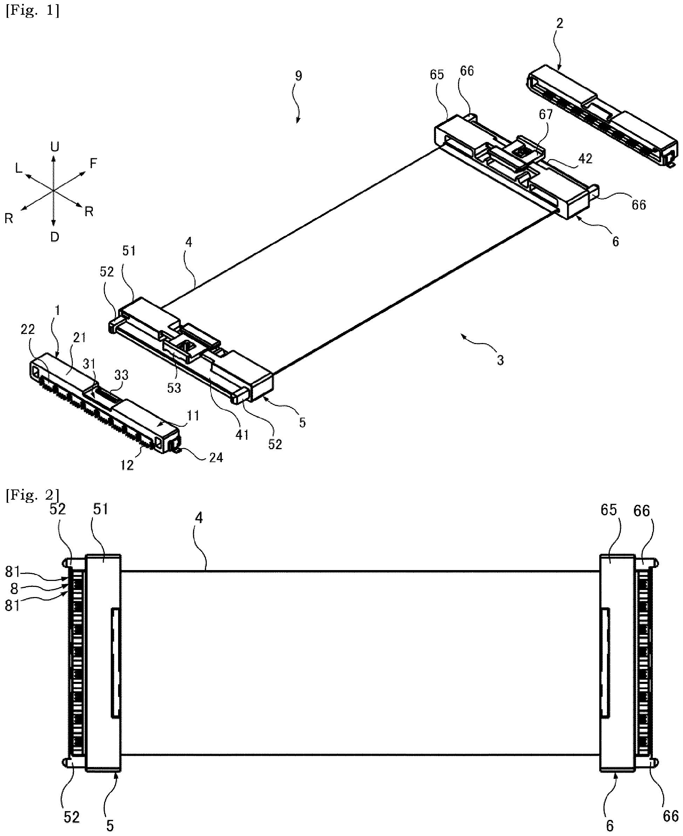

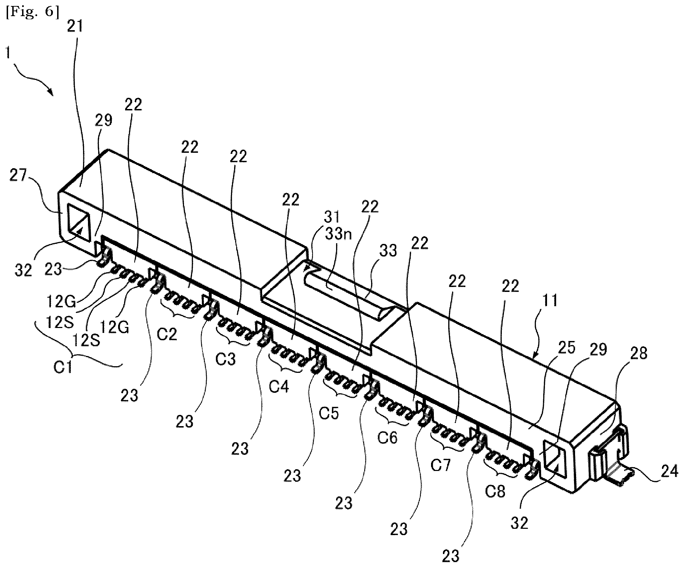

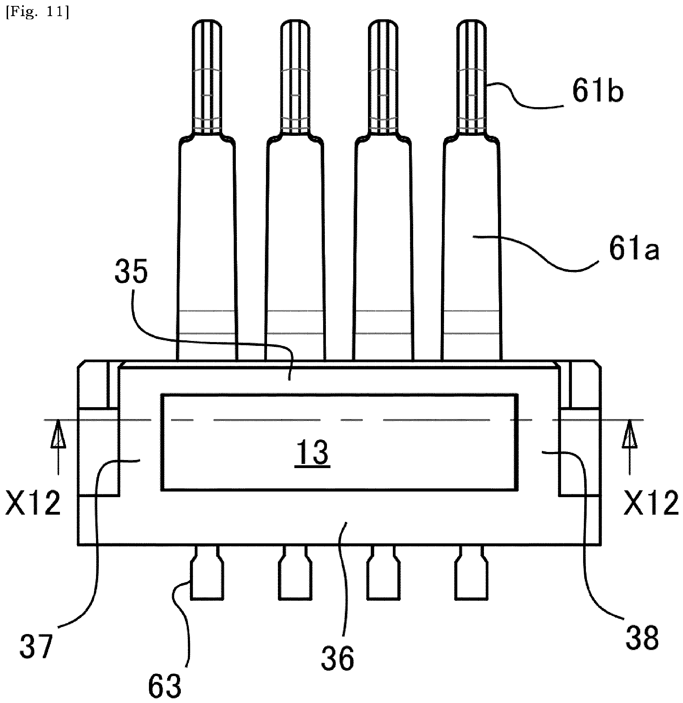

Hereinafter, non-limiting embodiments and features of the present invention would be discussed with reference to Figs. 1-17. A skilled person would be able to combine respective embodiments and/or respective features without requiring excess description, and would appreciate synergistic effects of such combinations. Overlapping descriptions among the embodiments are basically omitted. Referenced drawings aim mainly for describing inventions and are simplified for the sake of convenience of illustration. The respective features should be appreciated as universal features not only effective to a connector presently disclosed but also effective to other various connectors not disclosed in the present specification. In the present specification, languages such as first and second are used for differentiating same parts such as connectors in necessary situations but, the same parts can be differentiated alternatively or additionally in light of languages of relative positional relation or direction (front, rear, left, right, upper and lower).

High-frequency signal transmission device 9 has a (first ) connector 1, a (second) connector 2, and a cable device 3. The connectors 1,2 are ones of identical structure, and thus will be described without distinguishing them. In other words, descriptions on one connector would be applicable for the other one as it is, and vice versa. Detail descriptions on the configuration of the connector 1,2 would follow below.

The cable device 3 has a FPC (Flexible Printed Circuits) 4, a (first) plug member 5 attached to an end 41 of the FPC 4 to assist assembling of the FPC 4 and the connector 1, and a (second) plug member 6 attached to an end 42 of the FPC 4 to assist assembling of the FPC 4 and the connector 2. Note that, the FPC 4 is a non-limiting example of high-frequency signal transmission cable. The FPC may be referred alternatively to a flat cable.

The connectors 1,2 each is mechanically connected to the plug member 5,6 and electrically coupled to the FPC 4 (particularly to a group of contact pads arranged in respective end of the FPC 4). The plug member 5,6 are ones of identical structure and thus will be described without distinguishing them. The connector 1,2 may be referred to a receptacle connectors in relation to the FPC 4 and/or the plug member 5,6. Note that the plug members 5,6 are optional parts and can be omitted.

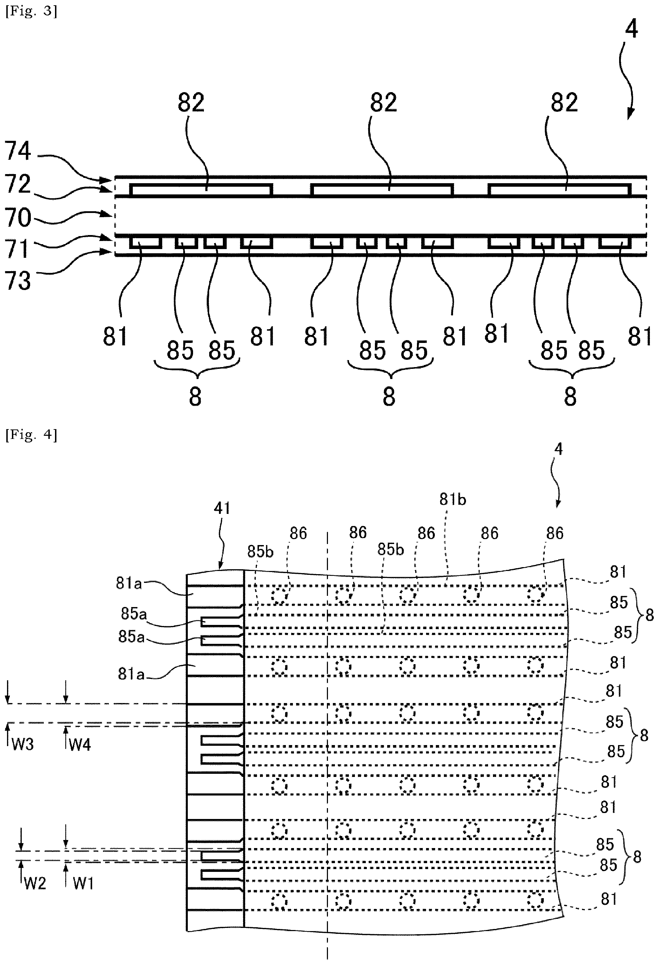

FPC 4 is a laminate of a dielectric layer 70, a (first) wiring layer 71, a (second) wiring layer 72, a cover layer 73 covering the wiring layer 71 and a cover layer 74 covering the wiring layer 72 (See Fig. 3). The FPC 4 is a cable with a flexibility sufficient for U-like bending, but a cable with no flexibility may be employed. The dielectric layer 70 may be a resin sheet having a given relative dielectric constant such as LCP (Liquid Crystal Polymer) and polyimide. Similarly, the cover layer 73,74 may be a resin film such as of LCP (Liquid Crystal Polymer) and polyimide. The cover layer is removed in the ends 41,42 of the FPC 4, resulting in fluctuation of stray capacitance between a signal line 85 and a first ground line 81 described below compared with a section covered by the cover layer. Wirings included in the wiring layer 71,72 may be metal foils such as copper foils.

At least M (M indicating a natural number of 2 or more) differential transmission lines 8 and at least 2×M first ground lines 81 (referred to as a group of first ground lines) are formed in the wiring layer 71. Signal lines 85 of differential transmission lines 8 and the first ground lines 81 are arranged in coplanar relation. At least M second ground lines 82 (referred to as a group of second ground lines) are formed in the wiring layer 72. Typically, number of the second ground lines 82 included in the group of second ground lines is half of number of the first ground lines 81 included in the group of first ground lines, but should not necessarily be limited to this. Note that, in the illustrated case, M=8 but should not be limited to this.

The group of first ground lines may be allocated to the M differential transmission lines 8 in accordance with a condition of at least two first ground lines per one differential transmission line 8 in non-overlap manner, and the group of second ground lines may be allocated to the M differential transmission lines 8 in accordance with a condition of at least one second ground line per one differential transmission line 8 in non-overlap manner. As a result of this, each of the differential transmission lines 8 is interposed between the (allocated) at least two first ground lines 81 (more particularly in a coplanar relation) and is opposed to the (allocated) at least one second ground line 82 (more particularly with the dielectric layer 70 interposed) (See Fig. 3). Such a configuration allows reduction of crosstalk otherwise caused when a ground line or GND plane is shared by the differential transmission lines. Note that in instances where the ground line or GND plane is shared by the differential transmission lines, there is a possibility that signal leaks from one differential transmission line to the other differential transmission line via the ground line or GND plane (e.g. common mode noise (or electrical current) transmitted from an apparatus to the ground line), and this may not be sufficiently avoided despite of employment of differential transmission system.

In some cases, one signal transmission channel is configured from (at least) total five wirings including four wirings in a first plane (i.e. two signal lines 85 of the differential transmission line 8 and two first ground lines 81) and one wiring in a second plane (i.e. one second ground line 82). Number of signal transmission channel may also be denoted by M. Advantageously, no ground line is shared by adjacent signal transmission channels on the FPC 4 (e.g. in the entire length of the FPC 4).

In the respective signal transmission channels, it would be preferred to electrically couple the respective first ground lines 81 to the common second ground line 82 via plural interlayer-wirings 86 so as to stabilize the potential of the first ground lines 81 and the second ground line 82 (See Fig. 4). Note that the first ground lines 81 are narrower in width than the second ground line 82. Furthermore in one signal transmission channel, the interlayer-wirings 86 for coupling one of the first ground lines 81 to the second ground line 82 and the interlayer-wirings 86 for coupling the other one of the first ground lines 81 to the second ground line 82 may preferably be same in number and may be arranged at a same pitch, but should not be limited to this. Plural individual third ground lines (not illustrated) may be formed on the cover layer 73 in a similar fashion as the second ground lines 82.

The signal line 85 may be shaped such that an exposed portion thereof being not covered by the cover layer 73 has a narrower width than a portion thereof covered by the cover layer 73 (See widths W1 and W2 in Fig. 4). For example, contact pads 85a at both ends of the signal line 85 are shaped to have a narrower width than an intermediate line 85b extending between these contact pads 85a. This allows absorbing of fluctuation in relative dielectric constant between the cover layer 73 and the air so that uniform signal transmission would be maintained. The contact pad 85a is formed to be narrower in width and thus the alignment accuracy required for electrical coupling between the FPC 4 and the connector 1,2 would be increased, but this may be avoided by employment of the plug member(s).

The first ground line 81 may be shaped such that an exposed portion thereof not covered by the cover layer 73 has a wider width than a portion thereof covered by the cover layer 73 (See widths W3 and W4 in Fig. 4). For example, contact pads 81a at both ends of the first ground line 81 are shaped to have a wider width than an intermediate line 81b extending between these contact pads, and an interspace between the contact pad 81a of the first ground line 81 and the contact pad 85a of the signal line 85 is narrowed in accordance with the wider width of the contact pad 81a. This allows absorbing of fluctuation in relative dielectric constant between the cover layer 73 and the air so that uniform signal transmission performance would be maintained. Even though the contact pad 81a is widened in width, a higher alignment accuracy for electrical coupling between the FPC 4 and the connectors 1,2 would be still required as the contact pad 85a is narrowed in width. Note that the width of the contact pad 85a of the signal line 85 may be equal to or less than 2/3 or 1/2 of the width of the contact pad 81a of the first ground line 81.

The contact pad 85a of the signal line 85 may be located offset away from the end of the FPC 4 than the contact pad 81a of the first ground line 81. Accordingly, when a contact portion of the contact terminal 12 of the connector 1 and the contact pad 85a of the signal line 85 are in contact, a length of open stab extending to the end of the signal line 85 from the contact position therebetween would be shorter.

Now we refer back to Fig. 1 for further discussion. The plug members 5,6 are attached to the ends 41,42 of the FPC 4. The plug member 5 has a plug body 51, a pair of bosses 52 arranged at both edges of the plug body 51 in its width direction, and a locked portion 53 located between the pair of bosses 52 in the width direction of the plug body 51. The plug body 51 is a frame with a space through which the inserted FPC 4 passes. Accordingly, as the FPC 4 is inserted into the plug member 5, the contact pads of the FPC 4 (i.e. the contact pads 81a of the first ground lines 81 and the contact pads 85a of the signal lines 85) are arranged between the pair of bosses 52, extending forward from the plug body 51, along the width direction of the FPC 4.

In more detail, plural unit arrays of contact pads are arranged in the width direction of the FPC 4, wherein in each unit array a pair of the contact pads 85a (of the signal lines 85) is interposed between paired contact pads 81a (of the first ground lines 81). In each unit array, the contact pad 85a is positioned offset from the end of the FPC 4 than the contact pad 81a. Descriptions on the plug member 5 would be applicable for the plug member 6 and descriptions thereof would be omitted (reference numbers 5,51-53 should be replaced with reference numbers 6,65-67).

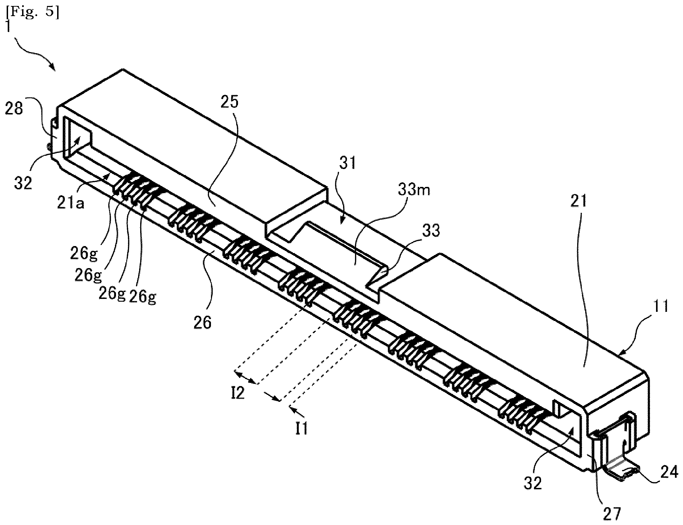

As illustrated in Figs. 5-7, the connector 1 has an insulator 11, and a group of contact terminals including at least M (M indicating a natural number of 2 or more) unit arrays C1-C8 arranged in a width direction of the insulator 11, each unit array including one or more signal contact terminals 12S and one or more ground contact terminals 12G (the signal contact terminal 12S and the ground contact terminal 12G may be collectively referred to as contact terminal 12 without distinguishing). In the present embodiment, the insulator 11 has an insulator body 21 and at least M attachment members 22 which are attached to the insulator body 21 and arranged in the width direction of the insulator 11. Furthermore, the respective unit arrays included in the at least M unit arrays C1-C8 are respectively supported by the respective attachment members included in the at least M attachment members 22. Accordingly, the unit arrays C1-C8 are supported by the attachment members 22 separately, enhancing the electrical isolation between the unit arrays C1-C8 and possibly facilitating reduction of crosstalk.

Number of contact terminals 12 supported by each unit array C1-C8 may be equal to or greater than 2. In some cases, each unit array includes one signal contact terminal 12S and one ground contact terminal 12G. In another case, each unit array includes two signal contact terminals 12S and two ground contact terminals 12G.

Advantageously, each attachment member 22 is configured to support four contact terminals 12 where a pair of signal contact terminals 12S is interposed between two ground contact terminals 12G. By attaching the M attachment members 22 to the insulator body 21, the contact terminals 12 are deployed in the insulator 11. The signal transmission channels each configured from the combination of the 4 contact terminals 12 are supported by separate attachment members 22, enhancing electrical isolation between the signal transmission channels and facilitating the reduction of crosstalk. Note that, regarding the number of the attachment members 22, it should not be limited to M=8 but it may be a natural number of M=2 or more.

The insulator 11 is an assembly of the insulator body 21 and the attachment members 22, and is shaped as a receptacle for receiving the FPC 4. Optionally, M+1 metal fixing member 23 are provided for attaching the attachment members 22 to the insulator body 21. Furthermore, two metal fixing members 24 are provided for fixing the insulator 11 onto a mounting board (e.g. motherboard or daughterboard) on which the connector 1 is mounted. Note that the width direction of the connector 1/the insulator 11 is identical to the width direction of the FPC 4 and similarly identical to the arrangement direction of the contact terminals 12 and the arrangement direction of the attachment members 22.

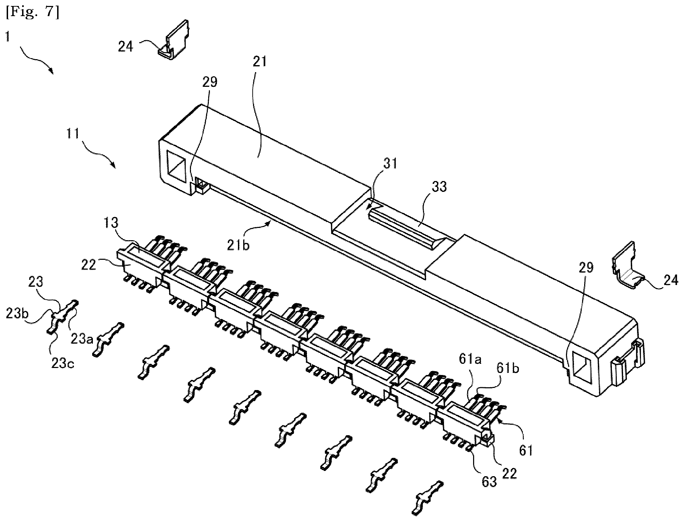

The insulator body 21 is a frame having a front mouth 21a at the side of the FPC 4 (see Fig. 5) and a rear mouth 21b at the opposite side of the FPC 4 (See Fig. 7), and has a top plate 25, a bottom plate 26, a left wall 27 and a right wall 28. Note that the front side indicates a direction directed toward the FPC 4 from the connector 1 and based on this direction, the left and right sides are also defined.

A recess 31 is formed at a top surface of the top plate 25, and a locking portion 33 is provided onto a bottom surface of the recess 31. A through-hole 32 (which may be simply referred to as a hole) is formed at a position adjacent to the left wall 27 and penetrates the insulator body 21 in the front-rear direction. Similarly, a through-hole 32 is formed at a position adjacent to the right wall 28 and penetrates the insulator body 21 in the front-rear direction. The bosses 52 of the plug member 5 are respectively inserted in to the through-holes 32, facilitating improved alignment of the FPC 4 relative to the connector 1. Note that the through-holes 32 are in spatial communication with the front mouth 21a of the insulator body 21, preventing the insulator 11 from being wider in width. A separation wall 29 is interposed between the attachment member 22 and the through-hole 32 in a state where the attachment member 22 has been attached to the insulator body 21, and thus the attachment member 22 is prevented from displacing due to the insertion of the boss 52 into the through-hole 32.

As the FPC 4 is fully inserted in the connector 1 to a given position, the locked portion 53 of the plug member 5 is locked by the locking portion 33 of the insulator body 21. Specific locking mechanism of the locking portion 33 and the locked portion 53 would be variously modified by a skilled person in the art. For example, the locked portion 53 may be a pivotable pawl that slides across a guide slope 33m (that is sloped upward toward the rear side) of the locking portion 33 as the FPC 4 is inserted into the connector 1, and then be in contact with a locking face 33n that extends downward from a top edge of the guide slope 33m.

In the bottom plate 26, the receiving grooves 26g are arranged in parallel, particularly units of given number (four) of receiving groove 26g are arranged in the width direction of the insulator body 21. Each receiving groove 26g extends in the front-rear direction so as to receive the contact terminal 12 supported by the attachment member 22. For example, each receiving groove 26g is defined by left and right wall surfaces extending in the front-rear direction and a bottom surface extending in the front-rear direction, and is open at the top, front and rear sides. The contact terminal 12 may be inserted into the receiving groove 26g via the opening of the receiving groove 26g at the top side. Depending on a shape of the contact terminal 12, it may be inserted via the rear opening of the receiving groove 26g. Pitch interval I1 between the receiving grooves 26g in a same unit is lesser than an interspace I2 between the units, and is equal to or less than 1/2 of the interspace I2. The number of the receiving grooves 26g included in the unit is equal to the number of contact terminals 12 supported by one attachment member 22.

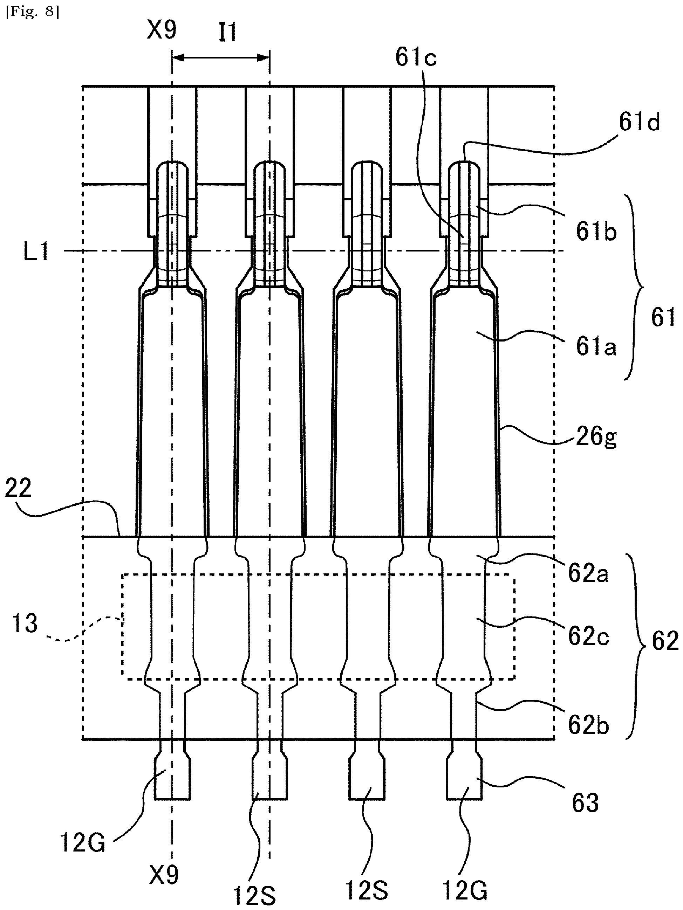

Each contact terminal 12 has an arm 61 that extends in a cantilever fashion forward from the attachment member 22, a securement portion 62 secured to the attachment member 22 and a contact portion 63 that extends rearward from the attachment member 22 (See Figs. 7 and 8). The arm 61 includes an arm plate 61a, and an arm bar 61b located farther from the attachment member 22 than the arm plate 61a and has a narrower width than the arm plate 61a. The arm plate 61a has a width in the left-right direction that gradually decreases as extending forward. The arm bar 61b extends forward farther from a front end of the arm plate 61a. The arm bar 61b extends forward obliquely and then extends downward obliquely so as to have a curved contact portion 61c that will contact the contact pad of the FPC 4. The arm bar 61b is employed and higher accuracy would be required for alignment relative to the contact pad of FPC 4, but this burden would be reduced by employing the plug member.

A portion of the contact terminal 12 between the contact portion 61c and the front end 61d of the arm bar 61b functions as an open stub, and is not necessary from a viewpoint of signal transmission. However, this is provided for a purpose of preventing the contact terminal 12 from buckling due to collision with the FPC 4. The contact portions 61c of the contact terminals 12 supported by a common attachment member 22 are arranged on a line L1 that is parallel to the width direction of the insulator 11, but should not necessarily be limited to this. The attachment members 22 may be appropriately attached to the insulator body 21 so that all of the contact portions 61c of the contact terminals 12 provided in the insulator 11 are arranged on the line L1.

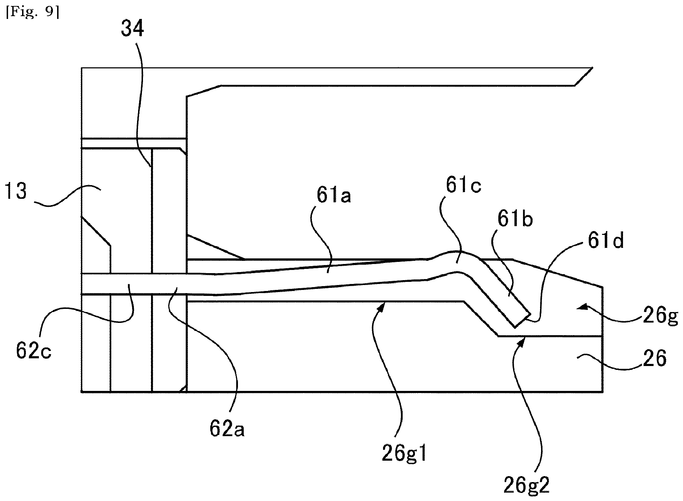

As the attachment member 22 is attached to the insulator body 21, the arms 61 of the contact terminals 12 of the attachment member 22 are respectively inserted into the receiving grooves 26g (See Fig. 9). This allows that a resin having a relative dielectric constant greater than one of the air e.g. PBT (Polybutylene terephthalate) or LCP (Liquid crystal polymer) or the like is interposed between the adjacent contact terminals 12, making it possible to regulate the stray capacitance between the adjacent contact terminals 12, resulting in better impedance-matching with the FPC 4. The contact terminal 12 is slightly curved out upward from the receiving groove 26g at the curved contact portion 61c, ensuring electrical coupling between the contact terminal 12 and the FPC 4.

The receiving groove 26g is shaped to be deeper at the side of a terminal end (front end) of the arm 61. In particular, the receiving groove 26g has a groove rear portion 26g1 that receives the arm plate 61a of the contact terminal 12 and a groove front portion 26g2 that receives an open stub of the contact terminal 12, and the depth of the groove front portion 26g2 is greater than the depth of the groove rear portion 26g1. Accordingly, the receiving groove 26g can receive the entirety of the arm 61 except for the curved-out portion of the contact portion 61c.

The width of the receiving groove 26g may be set corresponding to the width change of the arm 61. That is, the receiving groove 26g has a first groove width for receiving the arm plate 61a and a second groove width for receiving the arm bar 61b which is narrower than the first groove width. Additionally or alternatively, the receiving groove 26g has a minimum groove width at a position corresponding to the contact portion 61c. This allows increased amount of resin interposed between the contact terminals 12.

Note that the arm 61 is pushed downward due to contact with the FPC 4, and the front end 61d of the arm 61 may touch the bottom surface of the receiving groove 26g. In this situation, the FPC 4 and the contact terminal 12 are brought into a mutually pushing relationship, and the both would be more surely electrically coupled.

The securement portion 62 of the contact terminal 12 includes an exposed portion 62c that is exposed in an insertion hole 34 of the attachment member 22. The remainder 62a,62b of the securement portion 62 are embedded in the resin of the attachment member 22. The contact portion 63 extends rearward from the attachment member 22 but, various modifications would be possible with respect to its length, thickness and manner of bending and number of bending.

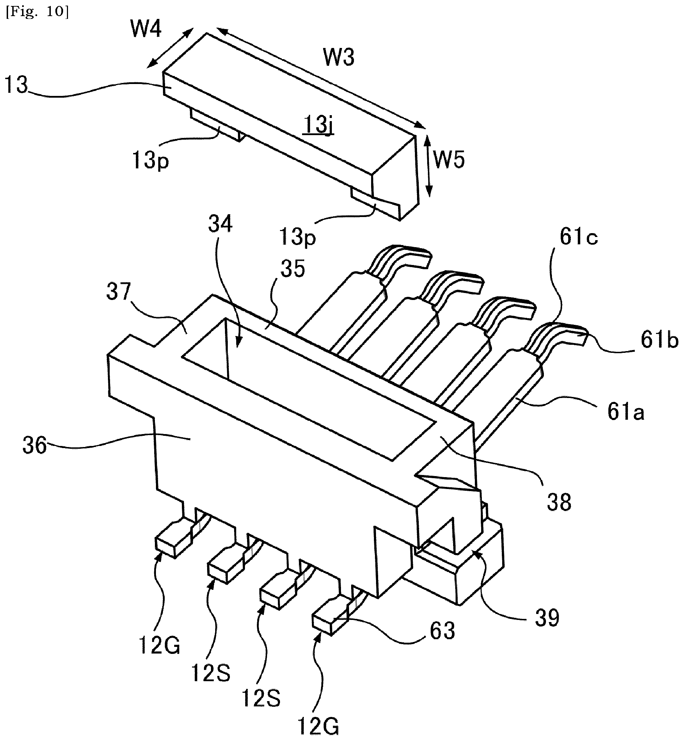

The attachment member 22 is a member with the insertion hole 34 to which an electroconductive part 13 is inserted (See Figs. 10-12). The attachment member 22 is a tubular body having a front wall 35, rear wall 36, left wall 37, and right wall 38 which define the insertion hole 34 into which the electroconductive part 13 may be pressed. Note that the insertion hole 34 is open at both top and bottom sides. The right wall 38 has a recess 39 that extends front-rear direction and is open at the right side. Similarly, the left wall 37 has a recess 39 that extends front-rear direction and is open at the left side.

The electroconductive part 13 may be a member in which conductive fillers are dispersed in an insulating resin. The electroconductive part 13 has a main body 13j and at least two legs 13p that protrude downward from the main body 13j. The main body 13j is a tapered member with a width W4 in the front-rear direction that decreases as extending downward. The legs 13p are solids that respectively protrude downward from the left and right edges of the main body 13j, and respectively touch, at its bottom surfaces, top surfaces of the exposed portions 62c of the ground contact terminals 12G. Note that the (maximum) width W3 of the electroconductive part 13 in the left-right direction is equal to or slightly greater or lesser than the interspace between the left wall 37 and the right wall 38 of the attachment member 22. Similarly, the (maximum) width W4 of the electroconductive part 13 in the front-rear direction is equal to or slightly greater or lesser than the interspace between the front wall 35 and the rear wall 36 of the attachment member 22. The width W5 of the electroconductive part 13 in the up-down direction changes in accordance with the existence and non-existence of the leg 13p.

As the electroconductive part 13 is inserted into the insertion hole 34 of the attachment member 22, the respective legs 13p of the electroconductive part 13 touch the exposed portions 62c of the ground contact terminals 12G located in the insertion hole 34. A space 13q is formed between the legs 13p and thus electrical coupling between the electroconductive part 13 and the signal contact terminals 12S is avoided.

The securement (e.g. embedding) of the contact terminals 12 on the attachment member 12 would be implemented by utilizing insert molding. Injection molding would be performed so that a resin adheres to the remainders 62a, 62b of the securement portion 62 of the contact terminal 12 and solidifies. The above-noted portions of the contact terminals 12 are located in a cavity defined by stationary mold and movable mold, followed by supply of molten resin into the cavity, and followed by cooling of the molds. The molten resin is solidified in the cavity as such, and the attachment member 22 is produced where the contact terminals 12 are partially embedded. Note that the insertion hole 34 is a space formed corresponding to a core located in the cavity for a purpose of positioning the contact terminals 12 during the injection molding.

As the contact terminals 12 are supported by the attachment member 22, positioning of the attachment members 22 to the insulator body 21 would be required. That is, if positioning accuracy of the attachment member 22 in the insulator body 21 was reduced, positioning accuracy of the contact terminals 12 in the connector 1 would be also reduced. From such a viewpoint, metal fixing members 23 may be utilized for positioning the attachment members 22 in the insulator body 21 in some cases.

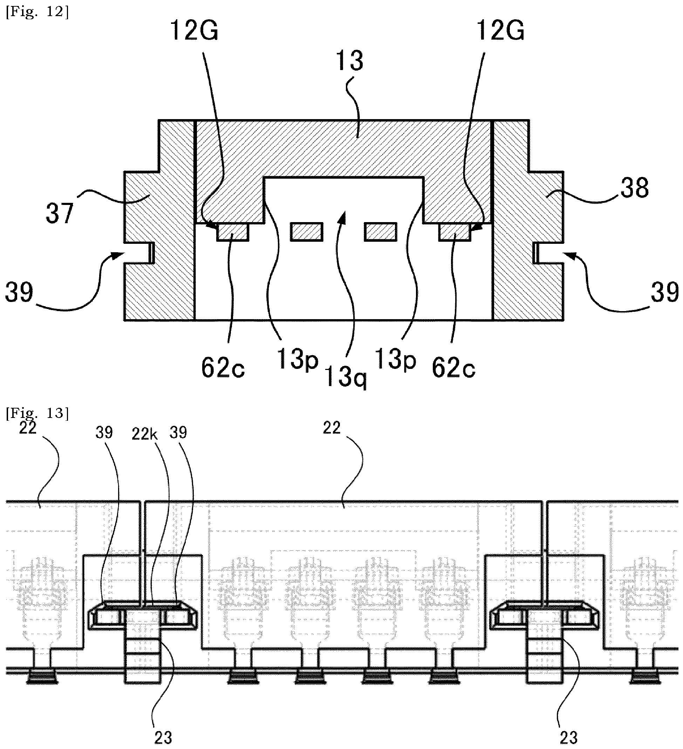

The metal fixing member 23 has an insertion portion 23a, a wing 23b protruding to the both left and right sides, and a bending portion 23c (See Fig. 7). When the attachment members 22 are placed adjacent in the width direction of the insulator 11, the recesses 39 of the adjacent attachment members 22 are combined to form an insertion slot 22k for the metal fixing member 23 (See Fig. 13). The insertion portion 23a of the metal fixing member 23 is inserted (preferably pressed) into the insertion slot 22k, thus preventing the attachment members 22 from displacing in the insulator body 21. The insertion portion 23a has a width that varies in the insertion direction of the insertion portion 23a into the insertion slot 22k and, for example, is shaped to be narrower in width at a position between the adjacent insertion holes 34 (or adjacent electroconductive parts 13). Accordingly, the metal fixing member 23 is suitably pressed into the insertion slot 22k. The wing 23b of the metal fixing member 23 collides the rear faces of the attachment members 22, defining a stop position for the inserted metal fixing member 23 and resulting in a situation where the attachment members 22 are pushed by the wing 23b from the rear side. The bending portion 23c may be soldered to a mounting substrate for the connector 1 through reflow process. The metal fixing members 23 may be coupled to a ground potential on the mounting substrate on which the connector 1 is mounted. This allows increased isolation between the signal transmission channels of the connector 1. In some cases, the insertion portion 23a of the metal fixing member 23 is inserted into a groove formed in the insulator body 21, thus effectively restricting displacement of the metal fixing member 23.

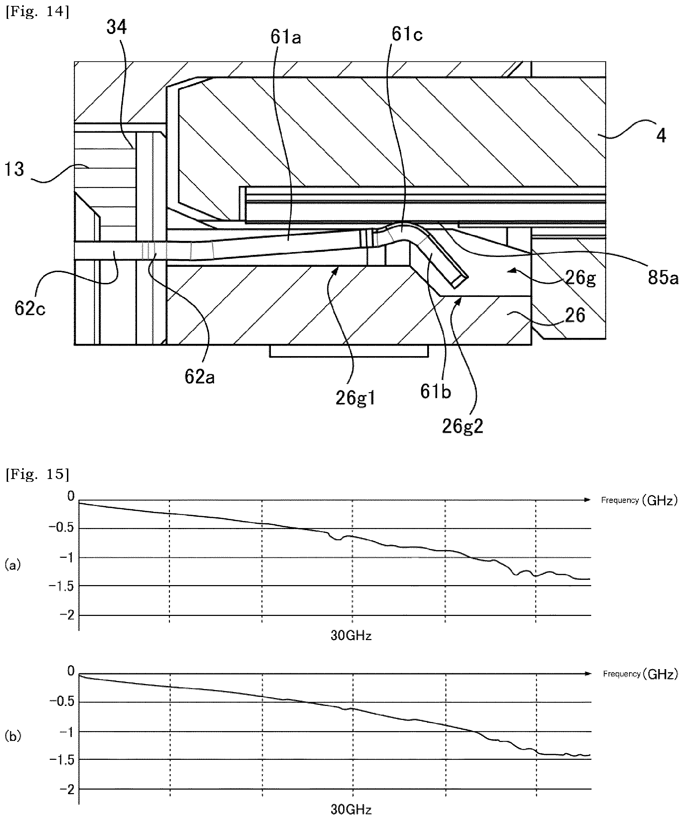

When assembling the plug member 5 and the connector 1 for a purpose of electrically coupling the FPC 4 to the connector 1, the boss 52 and the through-hole 32 are fitted, guiding the FPC 4 to be suitably inserted into the connector 1. After the FPC 4 is inserted into the insulator 11 via the front mouth 21a of the insulator 11, the FPC 4 is place on the bottom plate 26 of the insulator body 21. The contact portions 61c of the contact terminals 12 are slightly curved out upward from the receiving grooves 26g. Therefore, in accordance with insertion of the FPC 4, the bottom surface of the FPC 4 is brought into contact with the top surfaces of the contact portions 61c, and the contact portions 61c are pushed downward. After the FPC 4 is inserted to a given position, it is ensured that the contact portions 61c of the contact terminals 12 of the connector 1 and the contact pads 81a,85a of the FPC 4 are in contact respectively (See Fig. 14). In more detail, the contact portion 61c of the arm 61 of the signal contact terminal 12S touches the contact pad 85a of the signal line 85. Similarly, the contact portion 61c of the arm 61 of the ground contact terminals 12G touches the contact pad 81a of the first ground line 81.

What should be noted is that in the high-frequency signal transmission device 9 assembled from a combination of the FPC 4 and the connector 1,2, a ground potential is not shared between the respective signal transmission channels. In particular, a ground line is not shared between the differential transmission lines 8 of the FPC 4. A ground contact terminal 12 G is not shared between the pairs of the signal contact terminals 12S of the connector 1,2 to be electrically connected to the differential transmission lines 8. As such, the sharing of ground potential between the differential transmission lines in both of the FPC 4 and the connector 1,2 is avoided so that the electrical isolation is enhanced, and the crosstalk would be expectedly reduced. It would be possible to implement the non-sharing of the ground potential only in the FPC 4 or only in the connector 1,2 instead of in both of the FPC 4 and the connector 1,2.

Fig. 15 shows a result of simulation regarding insertion loss for the high-frequency signal transmission device (connectors connected to both ends of the cable device). Fig. 15 (a) shows a result of a case where first ground lines are shared by adjacent differential transmission lines, and the second ground line is shared by all of the differential transmission lines. Fig. 15(b) shows a result of the embodiment according to the present disclosure. As illustrated in Fig. 15, improvement in ripples about wavelength of 30GHz was achieved in the embodiment according to the present disclosure.

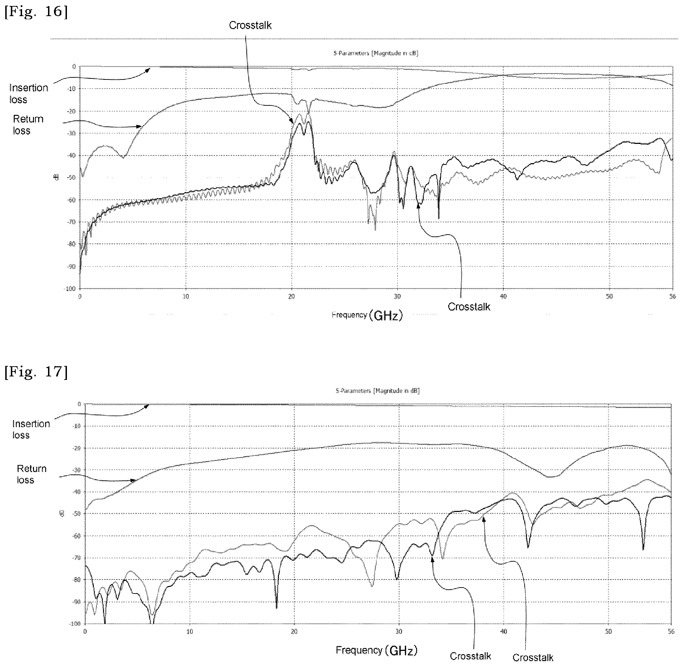

Fig. 16 shows a result of simulation of a connector according to a comparative example (i.e. a connector in which all unit arrays are supported by a common single attachment member). Fig. 17 shows a result of simulation of a connector according to the embodiment of present disclosure (i.e. a connector in which unit arrays are respectively supported by attachment members). Note that the simulation of the connector is done in a condition where a short cable and a substrate are connected to the connector, and it reflects a change in impedance caused by these connections.

As appreciated from comparison between Fig. 16 and Fig. 17, reduction of crosstalk was confirmed in the connector according to the embodiment of present disclosure. Moreover, reduction of ripples (e.g. a large ripple nearby 20GHz and so on) was also confirmed.

Based on the above teachings and disclosures, a skilled person in the art would be able to add various modifications to the respective embodiments. Shape of the contact terminal should not be limited to the disclosed one, and it would be possible to employ a contact terminal where two or more contact portions are formed in one contact terminal. It would also be possible to arrange the contact terminals so as to be in electrical contact with the contact pads at the both sides of the FPC. In particular, one array of contact terminals is arranged to be in contact with the contact pads at the top side of the FPC, and the other array of the contact terminals is arranged to be in electrical contact with contact pads at the bottom side of the FPC. As such, the FPC should not be limited to one with contact pads on its one side, but it would be possible to employ ones with contact pads at both sides.

### [Reference codes]

1,2: Connector
4: FPC
5,6: Plug member
8: Differential transmission line
9: High-frequency signal transmission device
11: Insulator
12: Contact terminal (12G: Ground contact terminal, 12S: Signal contact terminal )
13: Electroconductive part
21: Insulator body
22: Attachment member
70: Dielectric layer
71,72: Wiring layer
73,74: Cover layer
81: First ground line
82: Second ground line
85: Signal line

## Claims

1. A connector to which a high-frequency signal transmission cable is electrically coupled, the connector comprising:
an insulator;
a group of contact terminals including at least M (M indicating a natural number of 2 or more) unit arrays arranged in a width direction of the insulator, each unit array including one or more signal contact terminals and one or more ground contact terminals,
wherein the insulator including an insulator body and at least M attachment members which are attached to the insulator body and arranged in the width direction of the insulator, and
wherein the respective unit arrays included in the at least M unit arrays are respectively supported by the respective attachment members included in the at least M attachment members.

2. The connector of Claim 1, wherein each unit array includes 4 contact terminals in which a pair of signal contact terminals are interposed between two ground contact terminals.

3. The connector of Claim 2, wherein the attachment member retains an electroconductive part that electrically couple the two ground contact terminals included in the 4 contact terminals.

4. The connector of Claim 3, wherein the attachment member has an insertion hole to which the electroconductive part is inserted, the electroconductive part having at least two legs, each leg touching a portion of the ground contact terminal located and exposed in the insertion hole of the attachment member.

5. The connector of Claim 4, wherein the attachment member is a tubular body having at least a front wall, a rear wall, a left wall, and a right wall which define the insertion hole, the insertion hole being open at both top and bottom sides.

6. The connector of any one of Claims 1-5, wherein the signal contact terminal and the ground contact terminal have arms extending away from the attachment member, the insulator body includes a plurality of receiving grooves which respectively receive the arms, the receiving groove having a width set corresponding to width change of the arm.

7. The connector of Claim 6, wherein the arm includes an arm plate and an arm bar, the arm bar being located farther from the attachment member than the arm plate and having a width narrower than a width of the arm plate, and
the receiving groove has a first groove width for receiving the arm plate and a second groove width for receiving the arm bar, the second groove width being narrower than the first groove width.

8. The connector of Claim 7, wherein the arm has a contact portion that touches a contact pad provided in the high-frequency signal transmission cable, the receiving groove having a minimum groove width at a position corresponding to the contact portion.

9. The connector of any one of Claims 1-8, wherein the attachment members arranged adjacent in the width direction of the insulator have recesses which are combined to form an insertion slot for a metal fixing member.

10. The connector of Claim 9, wherein the metal fixing member has an insertion portion inserted into the insertion slot, and the insertion portion have a width that varies in an insertion direction of the insertion portion into the insertion slot.

11. The connector of any one of Claims 1-10, wherein the insulator body has a hole into which a boss of a plug member attached to an end of the high-frequency signal transmission cable is inserted, and a separation wall interposed between the hole and the attachment member.

12. The connector of any one of Claims 1-11, wherein the insulator body is a frame having a rear mouth to which the at least M attachment members are inserted and a front mouth to which the high-frequency signal transmission cable is inserted.

13. The connector of any one of Claims 1-12, further comprising at least M electroconductive parts, respective electroconductive parts included in the at least M electroconductive parts are respectively retained by respective attachment members included in the at least M attachment members.

14. The connector of Claim 13, wherein the attachment member has an insertion hole to which the electroconductive part is inserted and supports the signal and ground contact terminals such that the signal and ground contact terminals have exposed portions in the insertion hole.

15. A high-frequency signal transmission device comprising:
a connector of any one of claims 1-14; and
a high-frequency signal transmission cable electrically coupled to the connector, the high-frequency signal transmission cable including at least M signal transmission channels.
